# FASCICULE DE BREVET EUROPEEN

(11) **EP 0 644 153 B1**
(45) Date de publication et mention de la délivrance du brevet: **04.02.1998**
(21) Numéro de dépôt: 94402014.8
(22) Date de dépôt: 09.09.1994
(51) Int. Cl.: C01B 6/34, C01B 33/04

(54) **Procédé de séparation du silane à l'aide d'une membrane**
Verfahren zur Trennung eines Silans mit Hilfe einer Membran
Process for the separation of a silane with the aid of a membrane

(30) Priorité: 17.09.1993 FR 9311083
(43) Date de publication de la demande: 22.03.1995
(73) Titulaire: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventeur: Bouard, Pascal, F-91210 Draveil (FR); Labrune, Philippe, F-94100 Saint Maur (FR); Villermet, Alain, F-78220 Viroflay (FR); Gastiger, Michel, F-91400 Orsay (FR)
(74) Mandataire: Le Moenner, Gabriel

(56) Documents cités:
- EP-A- 0 239 190
- US-A- 4 178 224
- US-A- 4 941 893
- US-A- 4 957 513
- JOURNAL OF MEMBRANE SCIENCE, vol.70, 1992, AMSTERDAM NL pages 143 - 152 S.T.HSIEH, G.E.KELLER II 'Separation of hydrogen from silane via membranes: a step in the production of ultra-high-purity silicon'
- DATABASE WPI Week 8511, Derwent Publications Ltd., London, GB; AN 85-066277/11 & JP-A-60 022 902 (MITSUBISHI CHEM IND KK) 2 Février 1985

## Description

La présente invention concerne un procédé de séparation de gaz par membrane, et plus particulièrement la séparation du silane, fréquemment utilisé dans l'industrie de la microélectronique pour des opérations telles que la fabrication de silicium métal ou encore le dépot de silice SiO₂.

L'utilisation d'atmosphères comprenant des hydrures gazeux pose traditionnellement des questions liées :
a) Aux conditions de sécurité strictes dans lesquelles ces atmosphères doivent être mises en oeuvre. Elles présentent pour la plupart des risques de toxicité élevés auxquels s'ajoutent des risques liés au caractère inflammable de certains hydrures. Dans ce contexte, il est souvent recommandé de les utiliser en deçà d'une certaine concentration ou limite sécuritaire dans un gaz vecteur (cette limite variant d'un hydrure à l'autre), la difficulté étant que les applications citées ci-dessus nécessitent généralement des concentrations plus élevées que cette limite sécuritaire, puisqu'elles atteignent parfois plusieurs dizaines de %.
b) A leur coût élevé incitant les utilisateurs à tenter dans la mesure du possible de recycler l'hydrure ou le mélange d'hydrures n'ayant pas réagi au cours du procédé considéré mettant en oeuvre ce ou ces hydrures.

Dans un tel contexte, on comprend tout l'intérêt qu'il y aurait à pouvoir séparer de tels hydrures avec des objectifs tels que :
- L'épuration des mélanges obtenus à la sortie de générateurs de production d'hydrure gazeux qui, outre l'hydrure recherché, produisent des espèces résiduelles telles qu'un gaz inerte.

Mais il faut aussi citer, dans cette catégorie, le cas de générateurs d'hydrure, produisant un hydrure donné à partir d'un hydrure inférieur (par exemple du disilane à partir de monosilane) pour lequel il est utile de séparer, dans le mélange réactionnel obtenu, I'hydrure inférieur n'ayant pas réagit (toujous dans l'exemple cité le monosilane) pour le recycler à l'entrée du générateur;
- Le traitement des mélanges obtenus à la sortie de réacteurs mettant en oeuvre de tels hydrures ou mélanges d'hydrures : séparation des hydrures n'ayant pas réagi, et recyclage de ces hydrures à l'entrée du réacteur. On peut citer dans ce domaine l'exemple des réacteurs de fabrication de silicium métal à partir de silane gazeux SiH₄.
- La concentration sécuritaire d'hydrures dans un gaz vecteur : pour n'utiliser et ne transporter que des sources (le plus souvent des bouteilles) d'hydrures gazeux comportant une concentration en hydrure dans un gaz vecteur (neutre ou encore hydrogène) inférieure à la limite sécuritaire évoquée plus haut (par exemple 2% de silane), et ne concentrer l'hydrure ou le mélange d'hydrures que juste en amont du point d'utilisation où une concentration élevée en hydrure est requise.

Les procédés existants permettant de réaliser la séparation d'hydrures gazeux d'un milieu gazeux sont de façon générale très onéreux et présentent de réels dangers de manipulation, qu'il s'agisse de séparation par adsorption ou par distillation cryogénique.

On peut néanmoins citer les travaux récents du document US-A-4,941,893 proposant la séparation de composés gazeux du silicium (SiXₐH_{b}, incluant le silane) de l'hydrogène ou d'acides halogénés (HX, X : Cl, Br, I, F) à l'aide d'une membrane semi-perméable, et où est tout particulièrement recommandée et illustrée l'utilisation d'une membrane composite polysulfone/polysulfone sulfonaté. Les résultats obtenus dans le cas du silane sont tels que pour un mélange initial H₂/SiH₄ à 48.8 % de silane, la concentration en silane en sortie de membrane varie, selon le débit considéré à l'entrée de la membrane, d 'environ 52 % à environ 84 %, la concentration en sortie évolue entre environ 1.5 % et 25 % dans le cas d'une concentration en silane à l'entrée de 1 %.

On peut aussi mentionner le document US-A-4,957,513 où est évoquée la séparation par membrane d'hydrogène sélénié (H₂Se) d'un mélange gazeux contenant, outre H₂Se, H₂O et HCl, tel qu'obtenu en sortie d'un générateur d'hydrogène sélénié. Compte tenu des membranes utilisées et des propriétés de perméation de H₂Se dans ces membranes, le mélange enrichi en hydrogène sélénié est obtenu coté perméat de la membrane.

La présente invention a pour objectif de proposer un procédé de séparation du silane d'un milieu gazeux comportant au moins un des gaz du groupe constitué de He et Ar, procédé dont les performances permettent de séparer le silane avec une sélectivité élevée et ajustable.

L'aspect "ajustabilité" est tout particulièrement important dans l'optique de pouvoir produire, par une mise en oeuvre adéquate des paramètres du procédé, la concentration désirée d'hydrure (s) en sortie (ou rejet) de membrane, et de pouvoir faire varier sans difficulté cette concentration sur demande.

L'invention propose donc un procédé de séparation du silane d'un milieu gazeux contenant au moins un gaz du groupe constitué par Ar et He, caractérisé en ce que l'on fait passer le milieu gazeux dans un module membranaire, de façon à obtenir en sortie du module une concentration en silane supérieure à sa concentration initiale dans le milieu gazeux.

Par module membranaire, on entend selon l'invention, un ensemble d'une ou plusieurs membranes semi-perméables montées en série ou en parallèle, présentant de bonne propriétés de séparation du silane par rapport à un gaz vecteur neutre (sélectivité), comme c'est le cas pour des membranes du type polyimide ou encore polyaramide (polyimide aromatique). Cet ensemble de membranes peut comporter des membranes de caractéristiques différentes.

Le milieu gazeux traité ainsi sur le module membranaire, pourra provenir de sources très différentes, tant sur le plan de la composition du milieu, que de ses caractéristiques de pression et de débit, comme par exemple :
- Un mélange gazeux provenant d'un générateur d'hydrure, comprenant outre l'hydrure gazeux, des "impuretés" résiduelles.
- Un mélange gazeux, constituant en fait un mélange réactionnel, obtenu à la sortie d'un réacteur mettant en oeuvre le silane; ce milieu réactionnel contenant une proportion de silane n'ayant pas réagi; l'application du procédé selon l'invention à ce type de mélange, permet de recycler le mélange obtenu à la sortie du module membranaire à l'entrée du réacteur. On peut citer ici l'exemple d'un réacteur de dépôt (par exemple un réacteur de fabrication de silicium métallique), à partir de silane. L'application du procédé selon l'invention à ce type de réacteur permettant de recycler à l'entrée du réacteur le silane n'ayant pas réagi au cours du procédé de fabrication de silicium dont ce réacteur est le siège.
- Un mélange gazeux issu d'un stockage gazeux du type bouteille, comprenant une faible concentration de silane dans un gaz vecteur choisi dans le groupe constitué de Ar, He, cette concentration étant compatible avec les limites sécuritaires de concentration du silane dans ce gaz vecteur : le mélange obtenu à la sortie du module membranaire par l'application du procédé selon l'invention à ce type de mélange gazeux est alors dirigé vers un point d'utilisation où la concentration requise de l'hydrure est plus élevée que celle du stockage "sécuritaire".

Selon un aspect de l'invention, le milieu gazeux à traiter sur le module membranaire arrive sur ce module membranaire sous basse pression, compensée par le fait que l'on abaisse, du coté perméat de la membrane, la pression partielle du gaz ou milieu gazeux que l'on souhaite séparer du silane. Par "basse pression", on entend, selon l'invention, une pression située dans la gamme 10⁴ Pa absolus à 5 x 10⁵ Pa absolus. Cet aspect "basse pression" de l'invention, est tout particulièrement intéressant pour traiter des mélanges gazeux provenant par exemple d'un générateur d'hydrure ou encore de certains réacteurs utilisant des hydrures.

Selon une des mises en oeuvre de l'invention, on abaisse, du coté perméat de la membrane, la pression partielle du gaz que l'on souhaite séparer du silane, en mettant sous vide le coté perméat de la membrane. On atteint alors coté perméat de la membrane une pression de l'ordre de 1 à 100 Pa (vide primaire).

Selon une autre mise en oeuvre de l'invention, on abaisse, du coté perméat de la membrane, la pression partielle du gaz que l'on souhaite séparer du silane, en effectuant un balayage du coté perméat de la membrane, à l'aide d'un gaz, autre que celui que l'on souhaite séparer, et présentant par ailleurs une faible perméation du perméat vers l'intérieur de la membrane, de façon à éviter que ce gaz "outil" n'aille polluer l'intérieur de la membrane, et n'affecte de ce fait le résultat obtenu en sortie de membrane. On utilisera avantageusement, selon l'invention, comme gaz "outil", de l'azote, ou encore du SF₆.

Selon un autre aspect de l'invention, le milieu gazeux à traiter sur le module membranaire arrive sur ce module membranaire sous pression, cette pression pouvant atteindre , selon les sources de gaz 300 x 10⁵Pa et plus (cas de gaz conditionnés en bouteilles). On peut exprimer cette condition expérimentale en terme de différence de pression entre l'entrée et le coté perméat de la membrane. Cette différence se situera alors avantageusement , selon l'invention, en deça de 100 x 10⁵Pa absolus et préférentiellement dans la gamme 10⁵ Pa à 20 x 10⁵ Pa absolus.

On peut noter que pour certaines valeurs de pression un peu à la frontière entre les deux catégories "basse pression" et "en pression" (telles que 3 x 10⁵Pa), on peut parfois éviter l'utilisation d'une méthode d'abaissement de la pression partielle coté perméat (telle que mise sous vide), mais les résultats obtenus grâce à l'utilisation d'une telle méthode ne pourraient qu'en être améliorés.

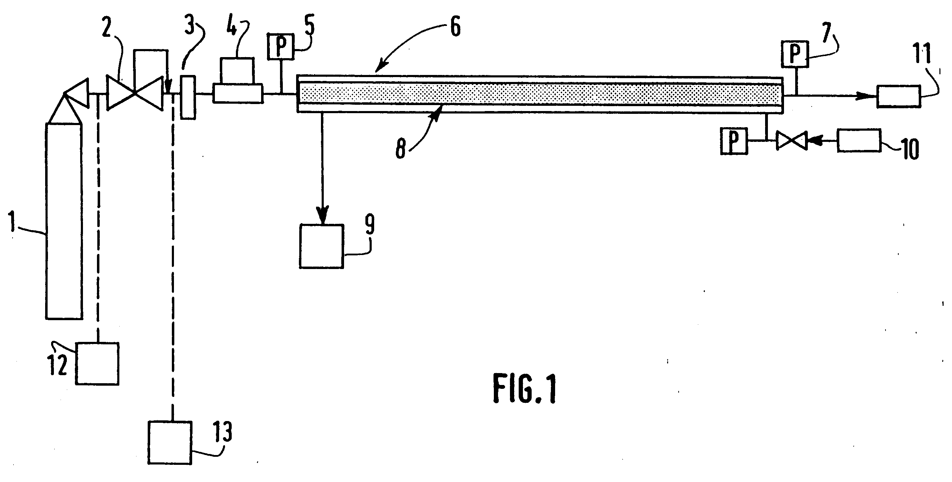

D'autres caractéristiques et avantages de la présente invention ressortiront de la description suivante de modes de réalisation donnés à titre illustratif mais nullement limitatif, faite en relation avec la figure unique (figure 1) qui est une représentation schématique d'une installation utilisée pour la mise en oeuvre du procédé selon l'invention.

Dans le mode de réalisation représenté sur la figure 1, on reconnait une bouteille 1 contenant le milieu gazeux à traiter. Le mélange est tout d'abord détendu sur un détendeur 2 jusqu'à atteindre une pression de l'ordre de 1 à 2 x 10⁵ Pa absolus, il passe ensuite sur un filtre à particules 3, puis dans un débimètre 4 avant de parvenir à un module membranaire 6. Un manomètre 5 est intercalé entre le débimètre et le module membranaire pour obtenir une mesure de pression du gaz avant son arrivée sur le module.

En pointillés, sont représentées deux lignes d'alimentation alternatives, où le milieu à traiter ne provient pas d'une bouteille, mais provient d'un réacteur mettant en oeuvre l'hydrure ou encore d'un générateur d'hydrure. Selon la pression du milieu gazeux issu de tels dispositifs (réacteur ou générateur), le dispositif sera raccordé à l'installation en amont du détendeur 2 (cas du dispositif 12) ou entre le détendeur 2 et le filtre 3 (cas du dispositif 13).

Le module membranaire 6 est, pour le mode de réalisation illustré figure 1, du type membrane à fibres creuses dont la couche active est un polyimide ou polyaramide (polyimide aromatique) et dont les caractéristiques permettent l'obtention d'une surface totale d'échange du module d'environ 0.25 m².

Un capteur de pression 7, permettant d'évaluer la pression du rejet enrichi en hydrure est intercalé en aval du module 6; le rejet enrichi en hydrure est envoyé vers un analyseur 11, pour évaluer la concentration en silane du rejet.

Pour ce qui est du perméat 8, l'installation permet d'effectuer un tirage au vide à l'aide d'une pompe à vide 9, Elle permet aussi de faire le choix d'un balayage du coté perméat 8 de la membrane à l'aide d'un gaz outil 10, ici en l'occurrence une réserve de SF₆.

Sont maintenant présentés quatre exemples de mise en oeuvre de l'invention, selon lesquels on traite une source initiale de silane, constituée par une bouteille contenant un mélange silane/hélium à 2% de silane en utilisant une installation comparable à celle représentée figure 1. Dans chaque cas, l'influence de paramètres tels que pression d'alimentation du module membranaire, température du module, débit de rejet, ou encore type de membrane utilisée a été étudiée.

Ces quatre exemples de mise en oeuvre n'ont utilisé ni mise sous vide ni balayage du coté perméat de la membrane.

Pour tous ces exemples, l'excellente reproductibilité des résultats sur plusieurs mois a montré la bonne inertie chimique des membranes utilisées vis à vis du silane, et le fait que les quelques ppm d'oxygène résiduel présent dans les atmosphères traitées n'entrainaient pas d'altération du fonctionnement de la membrane (formation éventuelle de particules).

### Premier exemple :

Le module membranaire utilisé est du type membrane à fibre creuse dont la couche active est un polyimide, mettant en oeuvre une surface totale d'échange du module d'environ 0.2 m².

La température du module était maintenue à 30 °C.

Pour ce premier exemple de mise en oeuvre, pour un débit en sortie de module (rejet) fixé à 0.17 l/mn, l'influence de la pression d'alimentation du module sur la concentration de silane à la sortie de module membranaire a été étudiée. Ainsi, pour une pression d'alimentation variant de 3 x 10⁵ Pa à 7 x 10⁵ Pa absolus ( débit d'alimentation variant entre 3 l/mn et 10 l/mn), on obtient, en sortie de module :
- une concentration de silane dans l'hélium variant de 22 % à 78 %,
- la pression correspondante en sortie varie de la pression atmosphérique à environ 3 x 10⁵ Pa absolu.

Pour une pression d'alimentation se situant au delà de 7 x 10⁵ Pa absolus, la concentration en silane dans l'hélium obtenue serait supérieure à 78 %, et elle serait inférieure à 22 % pour une pression d'alimentation plus faible que 3 x 10⁵ Pa absolus. Dans ce dernier cas, il serait tout particulièrement souhaitable d'abaisser la pression partielle de l'hélium côté perméat de la membrane à l'aide d'un balayage faisant intervenir un gaz "outil" ou encore par un tirage sous vide.

De même, en diminuant le débit de rejet, il est possible d'augmenter la concentration en silane à la sortie de module au delà de 90 %. Par exemple, pour une pression d'alimentation de 7 x 10⁵ Pa absolus, et un débit du rejet de 0.07 l/mn (pression du rejet de 3.3 x 10⁵ Pa absolus), un résultat de 94 % de silane dans l'hélium en sortie de module a été obtenu.

### Second exemple :

Ce second exemple met en oeuvre un module membranaire de mêmes type et caractéristiques que celui de l'exemple No 1. Ici aussi, la température du module est maintenue à 30 °C.

Ici encore, pour un débit en sortie de module (rejet) fixé, cette fois à 0.33 l/mn, l'influence de la pression d'alimentation du module sur la concentration de silane à la sortie de module a été étudiée. Ainsi, pour une pression d'alimentation variant de 3 x 10⁵ Pa à 7 x 10⁵ Pa absolus ( débit d'alimentation variant entre environ 3 l/mn et 10 l/mn), on obtient, en sortie de module, une concentration de silane dans l'hélium variant de 11% à 51 %. La pression du rejet évoluait ici dans l'intervalle [pression atmosphérique-2.5 x 10⁵ Pa] absolus.

### Troisième exemple :

Ce troisième exemple met en oeuvre un module membranaire du type membrane à fibres creuses dont la couche active est un polyaramide (polyimide aromatique) et dont les caractéristiques permettent l'obtention d'une surface totale d'échange du module d'environ 0.25 m². La température du module est maintenue à 30 °C.

Pour ce module de type différent de celui utilisé pour les deux premiers exemple, et, pour un débit en sortie de module (rejet) fixé cette fois à 0.28 l/mn, il est possible, en faisant varier la pression d'alimentation du module de 4 x 10⁵ Pa à 11 x 10⁵ Pa absolus ( débit d'alimentation variant entre environ 1.5 l/mn et 6.5 l/mn), d'obtenir, en sortie de module, une concentration de silane dans l'hélium variant de 8 à 41 % sous une pression variant de 1.5 x 10⁵ Pa à 8.2 x 10⁵ Pa absolu.

Une augmentation de pression entraine donc une nette augmentation de la sélectivité de la membrane.

Ici encore, en diminuant le débit de rejet (par exemple 0.07 l/mn, sous pression de rejet de 10.2 10⁵ Pa absolus), avec une pression d'alimentation de 11 x 10⁵ Pa absolus, un résultat de 92 % de silane dans l'hélium en sortie de module a été observé.

Quatrième exemple : Cet exemple met en oeuvre un module de mêmes type et caractéristiques que celui de l'exemple No 3. L'objectif est ici, pour un débit de rejet en sortie de module fixé à 0.42 l/mn, et pour une pression d'alimentation fixée à 11 x 10⁵ Pa absolus. d'étudier l'influence de la température du module sur la concentration en silane obtenue en sortie de module. Les résultats obtenus montrent que pour une température variant de 18 °C à 50 °C, la concentration en silane dans l'hélium en sortie de module se situait entre 23 % et 40 % sous une pression de rejet variant de 8.8 x 10⁵ Pa absolus (pour 18 °C) à 7 x 10⁵ Pa absolus (pour 50 °C).

Un augmentation de la température entraine donc une augmentation de la sélectivité de la membrane.

Les quatre derniers exemples cités montrent donc à quel point il est possible de modifier de façon notable et souple la concentration en silane obtenue en sortie de module, en agissant sur des paramètres tels que température du module, pression d'alimentation du module et débit du rejet.

Ils apportent une réponse interessante au problème de la concentration de silane pour des postes utilisateurs nécessitant une concentration en silane dans l'hélium de quelques dizaines de %, en partant d'un stockage sécuritaire contenant seulement 2 % de silane.

## Revendications

1. Procédé de séparation du silane d'un milieu gazeux contenant au moins un gaz du groupe formé par Ar et He, dans lequel :
a) on fait passer le milieu gazeux contenant le silane dans un module de séparation membranaire, comportant au moins une membrane de type polyimide ou polyaramide;
b) on ajuste au moins l'un des paramètres compris dans le groupe formé de la pression d'alimentation en gaz dudit module, la température dudit module, le débit en sortie rejet dudit module, de façon à obtenir, en sortie rejet du module, un mélange gazeux dont la concentration en silane soit supérieure à la concentration en silane du dit milieu gazeux.

2. Procédé selon la revendication 1, caractérisé en ce que l'on augmente la concentration en silane dudit mélange gazeux obtenu en sortie rejet dudit module, par hausse de ladite pression d'alimentation, et/ou hausse de la température dudit module, et/ou baisse du débit de gaz en sortie rejet dudit module.

3. Procédé selon la revendication 1, caractérisé en ce que l'on diminue la concentration en silane dudit mélange gazeux obtenu en sortie rejet dudit module, par baisse de ladite pression d'alimentation, et/ou baisse de la température dudit module, et/ou hausse du débit de gaz en sortie rejet dudit module.

4. Procédé selon la revendication 1, caractérisé en ce que le milieu gazeux arrive sous pression sur le module membranaire, la différence de pression entre l'entrée et le coté perméat de la membrane n'excédant pas 100 x 10⁵ Pa absolus.

5. Procédé selon la revendication 4, caractérisé en ce que la différence de pression entre l'entrée et le coté perméat de la membrane est située dans l'intervalle 10⁵ Pa à 20 x 10⁵ Pa absolus.

6. Procédé selon la revendication 1, caractérisé en ce que le milieu gazeux arrive sur le module membranaire sous basse pression.

7. Procédé selon la revendication 6, caractérisé en ce que l'on compense la dite basse pression, en abaissant, du coté perméat de la membrane, la pression partielle du milieu gazeux que l'on sépare du silane.

8. Procédé selon la revendication 7, caractérisé en ce que l'on abaisse, du coté perméat (8) de la membrane (6), la pression partielle du milieu gazeux que l'on sépare du silane en utilisant une des méthodes suivantes :
- on effectue une mise sous vide du coté perméat (8) de la membrane (6);
- on effectue un balayage du coté perméat (8) de la membrane (6), à l'aide d'un gaz, présentant une faible perméation du perméat vers l'intérieur de la membrane.

9. Procédé selon la revendication 8, caractérisé en ce que le gaz utilisé pour effectuer le balayage est de l'azote.

10. Procédé selon la revendication 8, caractérisé en ce que le gaz utilisé pour effectuer le balayage est du SF₆.

11. Procédé selon l'une des revendications 6 à 10, caractérisé en ce que la pression du milieu gazeux à séparer qui arrive sur le module membranaire se situe dans l'intervalle 10⁴ Pa à 5 x 10⁵Pa absolus.

12. Procédé selon l'une des revendications 1 à 11, caractérisé en ce que le milieu gazeux traité dans le module membranaire est issu d'un générateur de silane.

13. Procédé selon l'une des revendications 1 à 11, caractérisé en ce que :
a) le milieu gazeux traité sur le module membranaire est constitué par le mélange réactionnel obtenu à la sortie d'un réacteur mettant en oeuvre le silane, ce milieu réactionnel contenant une proportion de silane n'ayant pas réagi;
b) le mélange obtenu à la sortie du module membranaire (6) est ensuite recyclé à l'entrée du réacteur.

14. Procédé selon la revendication 13, caractérisé en ce que le réacteur est un réacteur de dépôt, mettant en oeuvre le silane comme précurseur gazeux du silicium.

15. Procédé selon l'une des revendications 1 à 11, caractérisé en ce que :
a) le milieu gazeux traité sur le module membranaire est issu d'un stockage gazeux du type bouteille (1), comprenant une faible concentration de silane dans un gaz vecteur choisi dans le groupe constitué de Ar, He, cette concentration étant compatible avec les limites sécuritaires de concentration du silane dans le dit gaz vecteur;
b) le mélange obtenu à la sortie du module membranaire (6) est alors dirigé vers un point d'utilisation où la concentration requise en silane est plus élevée que celle du stockage de l'étape a).

## Claims

1. Process for separating silane from a gaseous medium containing at least one gas from the group consisting of Ar and He, wherein :
a - the gaseous medium containing silane is passed through a membranous separation module having at least one membrane of the polyimide or polyaramide type;
b - adjustments are made to at least one of the parameters included within the group consisting of the pressure of the gas supply to the said module, the temperature of the said module and the flow rate at the discharge outlet from the said module, so as to obtain, at the discharge outlet from the module, a gaseous mixture of which the silane concentration is greater than the silane concentration of the said gaseous medium.

2. Process according to claim 1, characterized in that the silane concentration in the said gaseous mixture obtained at the discharge outlet from the said module is increased by raising the said supply pressure, and/or raising the temperature of the said module and/or reducing the flow rate of the gas at the discharge outlet from the said module.

3. Process according to claim 1, characterized in that the silane concentration in the said gaseous mixture obtained at the discharge outlet from the said module is reduced by lowering the said supply pressure, and/or lowering the temperature of the said module and/or increasing the flow rate of the gas at the discharge outlet from the said module.

4. Process according to claim 1, characterized in that the gaseous medium arrives under pressure at the membranous module, the difference in pressure between the inlet and permeate side of the membrane not exceeding 100 × 10⁵ Pa absolute.

5. Process according to claim 4, characterized in that the difference in pressure between the inlet and the permeate side of the membrane is situated within the interval 10⁵ Pa to 20 × 10⁵ Pa absolute.

6. Process according to claim 1, characterized in that the gaseous medium arrives at the membranous module under a low pressure.

7. Process according to claim 6, characterized in that the said low pressure is compensated for by lowering, at the permeate side of the membrane, the partial pressure of the gaseous medium from which silane is separated.

8. Process according to claim 7, characterized in that the partial pressure of the gaseous medium from which silane is separated is lowered, on the permeate side (8) of the membrane 6), by using one of the following methods :
- the permeate side (8) of the membrane (6) is put under vacuum;
- the permeate side (8) of the membrane (6) is purged with a gas having a low degree of permeation from the permeate to the interior of the membrane.

9. Process according to claim 8, characterized in that the gas used for purging is nitrogen.

10. Process according to claim 8, characterized in that the gas used for purging is SF₆.

11. Process according to one of claims 6 to 10, characterized in that the pressure of the gaseous medium to be separated which arrives at the membranous module is situated within the interval 10⁴ Pa to 5 × 10⁵ Pa absolute.

12. Process according to one of claims 1 to 11, characterized in that the gaseous medium treated in the membranous module is supplied by a silane generator.

13. Process according to one of claims 1 to 11, characterized in that :
a) the gaseous medium treated in the membranous module consists of the reaction mixture obtained at the outlet from a reactor using silane, this reaction medium containing a proportion of unreacted silane;
b) the mixture obtained at the outlet from the membranous module (6) is then recycled to the inlet of the reactor.

14. Process according to claim 13, characterized in that the reactor is a deposition reactor, using silane as a gaseous precursor of silicon.

15. Process according to one of claims 1 to 11, characterized in that :
a) the gaseous medium treated in the membranous module is provided by a gas storage vessel of the cylinder type (1) containing a low concentration of silane in a carrier gas selected from the group consisting of Ar, He, this concentration being compatible with the safety concentration limits of silane in the said carrier gas;
b) the mixture obtained at the outlet from the membranous module (6) is then directed to a point of use where the required concentration of silane is higher than that in the storage vessel of stage a).

## Patentansprüche

1. Verfahren zur Abtrennung von Silan aus einem Gasmedium, welches wenigstens ein Gas aus der aus Ar und He gebildeten Gruppe enthält, gemäß welchem:
a) das Gasmedium, welches das Silan enthält, in ein Membran-Abtrennungsmodul geleitet wird, welches wenigstens eine Membran des Polyamid- oder Polyaramid-Typs umfaßt;
b) wenigstens einer der Parameter aus der Gruppe Gaszuführungsdruck des genannten Moduls, Temperatur des genannten Moduls und Durchsatz am Rückhalteauslaß des genannten Moduls derart eingestellt wird, daß am Rückhalteauslaß des Moduls ein Gasgemisch eingestellt wird, dessen Konzentration an Silan höher ist als die Konzentration an Silan in dem Gasmedium.

2. Verfahren nach Anspruch 1, dadurch gekennzeichnet, daß die Silan-Konzentration am Rückhalteauslaß des genannten Moduls durch Erhöhung des genannten Gaszuführungsdrucks, und/oder Temperaturerhöhung des genannten Moduls und/oder Verringerung des Durchsatzes am Rückhalteauslaß des genannten Moduls erhöht wird.

3. Verfahren nach Anspruch 1, dadurch gekennzeichnet, daß die Silan-Konzentration am Rückhalteauslaß des genannten Moduls durch Verringerung des genannten Gaszuführungsdrucks und/oder Erniedrigung der Temperatur des genannten Moduls und/oder Erhöhung des Durchsatzes am Rückhalteauslaß des genannten Moduls verringert wird.

4. Verfahren nach Anspruch 1, dadurch gekennzeichnet, daß das Gasmedium unter Druck in das Membranmodul eintritt und die Druckdifferenz zwischen dem Einlaß und der Permeat-Seite der Membran 100 x 10⁵ Pa (absolut) nicht überschreitet.

5. Verfahren nach Anspruch 4, dadurch gekennzeichnet, daß die Druckdifferenz zwischen dem Einlaß und der Permeat-Seite der Membran in dem Intervall 10⁵ Pa bis 20 x 10⁵ Pa (absolut) liegt.

6. Verfahren nach Anspruch 1, dadurch gekennzeichnet, daß das Gasmedium in das Membranmodul unter niedrigem Druck eintritt.

7. Verfahren nach Anspruch 6, dadurch gekennzeichnet, daß der genannte niedrige Druck dadurch kompensiert wird, daß der Partialdruck des Gasmediums, das man vom Silan abtrennt, seitens der Permeat-Seite der Membran erniedrigt wird.

8. Verfahren nach Anspruch 7, dadurch gekennzeichnet, daß der Partialdruck des Gasmediums, das man vom Silan abtrennt, seitens der Permeat-Seite (8) der Membran (6) durch Anwendung einer der folgenden Methoden erniedrigt wird:
- Es wird seitens der Permeat-Seite (8) der Membran (6) Vakuum angelegt;
- Es wird eine Spülung seitens der Permeat-Seite (8) der Membran (6) mit Hilfe eines Gases durchgeführt, was eine geringe Permeation des Permeats ins Innere der Membran mit sich bringt.

9. Verfahren nach Anspruch 8, dadurch gekennzeichnet, daß das zur Durchführung der Spülung verwendete Gas Stickstoff ist.

10. Verfahren nach Anspruch 8, dadurch gekennzeichnet, daß das zur Durchführung der Spülung verwendete Gas SF₆ ist.

11. Verfahren nach einem der Ansprüche 6 bis 10, dadurch gekennzeichnet, daß der Druck des zu trennenden Gasmediums, das in das Membranmodul eintritt, im Bereich 10⁴ Pa bis 5 x 10⁵ Pa (absolut) liegt.

12. Verfahren nach einem der Ansprüche 1 bis 11, dadurch gekennzeichnet, daß das in dem Membranmodul verarbeitete Gasmedium einem Silan-Generator entstammt.

13. Verfahren nach einem der Ansprüche 1 bis 11, dadurch gekennzeichnet, daß:
a) das in dem Membranmodul verarbeitete Gasmedium aus dem Reaktionsgemisch besteht, welches am Auslaß eines Reaktors erhalten wird, der Silan verarbeitet, wobei dieses Reaktionsmedium einen Silan-Anteil enthält, der nicht reagiert hat;
b) das am Auslaß des Membranmoduls (6) erhaltene Gemisch anschließend zum Einlaß des Reaktors zurückgeführt wird.

14. Verfahren nach Anspruch 13, dadurch gekennzeichnet, daß der Reaktor ein Abscheidungsreaktor ist, der Silan als gasförmige Vorstufe des Siliziums verarbeitet.

15. Verfahren nach einem der Ansprüche 1 bis 11, dadurch gekennzeichnet, daß:
a) das in dem Membranmodul verarbeitete Gasmedium einer Gasbevorratung vom Flaschen-Typ (1) entstammt, welche eine geringe Silan-Konzentration in einem Trägergas ent-hält, das aus der aus Ar, He gebildeten Gruppe ausgewählt ist, wobei diese Konzentration mit den Sicherheitsgrenzen der Silan-Konzentration in dem genannten Trägergas übereinstimmt;
b) das am Auslaß des Membranmoduls (6) erhaltene Gemisch dann einem Anwendungsort zugeführt wird, an dem die erforderliche Silan-Konzentration höher als diejenige der Bevorratung gemäß Stufe a) ist.
